**Europäisches Patentamt**

**European Patent Office**

**Office européen des brevets**

(19)

(11) Veröffentlichungsnummer: **0 619 580 A1**

(12) **EUROPÄISCHE PATENTANMELDUNG**

| | |
|---|---|
| (21) Anmeldenummer: **94104293.9** | (51) Int. Cl.5: **G11C 29/00** |
| (22) Anmeldetag: **18.03.94** | |

| | |
|---|---|
| (30) Priorität: **08.04.93 DE 4311653** | (71) Anmelder: **TELDIX GmbH** **Postfach 10 56 08,** **Grenzhöfer Weg 36** **D-69046 Heidelberg (DE)** |
| (43) Veröffentlichungstag der Anmeldung: **12.10.94 Patentblatt 94/41** | |
| (84) Benannte Vertragsstaaten: **DE FR GR IT** | (72) Erfinder: **Tupac-Yupanqui, Jose** **Hermann-Löns-Weg 57** **D-69207 Sandhausen (DE)** |
| | (74) Vertreter: **Wiechmann, Manfred, Dipl.-Ing.** **ANT Nachrichtentechnik GmbH,** **Patentabteilung,** **Gerberstrasse 33** **D-71522 Backnang (DE)** |

(54) **Verfahren zum Überwachen des Inhalts eines Datenspeichers.**

(57) Ein Verfahren, das mit möglichst wenigen Meßpunkten auskommt, um den Inhalt eines Datenspeichers zu überwachen, besteht darin, daß der Speicher in Speichersegmente, von denen jedes aus
mehreren Speicherzellen besteht, aufgeteilt wird, daß
für jedes Speichersegment aus der Häufigkeit an
Zugriffen auf das Speichersegment und dessen
Speicherzellenzahl eine Zugriffswahrscheinlichkeit
bestimmt wird und daß die Zahl der als Überwachungs-Meßpunkte dienenden Speicherzellen in den
einzelnen Speichersegmenten proportional zu der für
jedes Speichersegment ermittelten Zugriffswahrscheinlichkeit gewählt wird.

EP 0 619 580 A1

Rank Xerox (UK) Business Services
(3. 10 / 3.0 9 / 3.3.4)

Bei Datenspeichern in Rechnersystemen können unerlaubte Schreibzugriffe vorkommen und auch andere Fehler, wie z.B. Ausfälle einzelner Speicherzellen, auftreten.

Damit solche Fehler erkannt werden können, benötigt man eine Überwachung des Speichers. Deshalb liegt der Erfindung die Aufgabe zugrunde, ein Überwachungsverfahren für Datenspeicher anzugeben, das mit möglichst wenigen Meßpunkten im Speicher auskommt, um auftretende Fehler mit hoher Zuverlässigkeit lokalisieren zu können.

Erfindungsgemäß wird diese Aufgabe durch die Merkmale des Patentanspruchs gelöst.

Die Erfindung wird nachfolgend näher erläutert.

Der zu überwachende Speicher wird in Segmente S1, S2... Sk unterteilt, von denen jedes aus mehreren Speicherzellen besteht. Zentrale Prozessoreinheiten (CPU) greifen auf Speicherzellen in den einzelnen Speichersegmenten zu. Wieviele solche Zugriffe auf jedes Speichersegment innerhalb einer vorgegebenen Zeit erfolgen, wird registriert. Für das i-te (i = 1...k) Speichersegment $S_i$ wird man also eine Zugriffshäufigkeit $n_i$ ermitteln.

Somit läßt sich jedem Speichersegment $S_i$ eine Zugriffswahrscheinlichkeit $p_i$ ($n_i$, $g_i$) zuordnen, die von der Zugriffshäufigkeit ni und der Größe $g_i$ (Zahl der Speicherzellen) des Speichersegments $S_i$ abhängt. Dabei gilt:

$$\sum_{i=1}^{k} p_i = 1.$$

Je nach dem mit welcher Zugriffswahrscheinlichkeit $p_i$ ein Speichersegment $S_i$ bewertet worden ist, wird proportional zu $p_i$ die Zahl der als Überwachungs-Meßpunkte dienenden Speicherzellen in dem betreffenden Speichersegment $S_i$ gewählt.

In die Wichtung eines Speicherelements, von der die Zahl der überwachten Speicherelemente abhängt, kann neben der Zugriffswahrscheinlichkeit $p_i$ auch noch die Wichtigkeit der Information, welche in dem betreffenden Speichersegment abgespeichert wird, einfließen.

Mit dieser Art der Meßpunkteverteilung lassen sich mit großer Sicherheit unerlaubte Speicherzugriffe oder sonstige Speicherfehler registrieren. An den Meßpunkten können z.B. Zählerwerte, Adressen, Kennungen oder Codes überprüft werden.

**Patentansprüche**

1. Verfahren zum Überwachen des Inhalts eines Datenspeichers, dadurch gekennzeichnet, daß der Speicher in Speichersegmente, von denen jedes aus mehreren Speicherzellen besteht, aufgeteilt wird, daß für jedes Speichersegment aus der Häufigkeit an Zugriffen auf das Speichersegment und dessen Speicherzellenzahl eine Zugriffswahrscheinlichkeit bestimmt wird und daß die Zahl der als Überwachungs-Meßpunkte dienenden Speicherzellen in den einzelnen Speichersegmenten proportional zu der für jedes Speichersegment ermittelten Zugriffswahrscheinlichkeit gewählt wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | INTERNATIONAL TEST CONFERENCE 1989 PROCEEDINGS, 29 - 31 AUGUST 1989, WASHINGTON US Seiten 439 - 451 J. SAVIR ET AL. 'Testing for coupled cells in random-access memories' * Zusammenfassung * * Seite 440, rechte Spalte, Zeile 30 - Zeile 46 * * Seite 444, linke Spalte, Zeile 1 - rechte Spalte, Zeile 26 * --- | 1 | G11C29/00 |
| A | WO-A-92 12520 (SIEMENS) * das ganze Dokument * ----- | 1 | |

RECHERCHIERTE SACHGEBIETE (Int.Cl.5)

G11C
G06F

Der vorliegende Recherchenbericht wurde für alle Patentansprüche erstellt

| Recherchenort | Abschlußdatum der Recherche | Prüfer |
|---|---|---|
| BERLIN | 15. Juli 1994 | Masche, C |